# EUROPEAN PATENT SPECIFICATION

(11) **EP 4 346 073 B1**
(45) Date of publication and mention of the grant of the patent: **18.11.2026**
(21) Application number: 22197892.7
(22) Date of filing: 27.09.2022
(51) Int. Cl.: H02M 1/00, H02M 3/335, H05B 45/385, G01R 19/25

(54) **SYNCHRONOUS FLYBACK CONVERTER WITH DYNAMIC CURRENT SENSING TIMING**
SYNCHRONER SPERRWANDLER MIT DYNAMISCHER STROMMESSUNGSZEIT
CONVERTISSEUR FLYBACK À SYNCHRONISATION DE DÉTECTION DE COURANT DYNAMIQUE

(43) Date of publication of application: 03.04.2024
(73) Proprietor: Tridonic GmbH & Co KG, 6851 Dornbirn (AT)
(72) Inventor: Stark, Stefan, 6850 Dornbirn (AT); Nachbaur, Stefan, 6850 Dornbirn (AT); Schertler, Markus, 6850 Dornbirn (AT); Walch, Patrick, 6850 Dornbirn (AT)
(74) Representative: Rupp, Christian

(56) References cited:
- EP-A1- 3 926 808
- EP-A1- 4 009 506
- DE-A1- 102010 001 181
- DE-A1- 3 705 468

## Description

The invention relates to a synchronous flyback converter. Especially, the invention relates to measuring a current within the converter.

In synchronous flyback converters, an operating current is measured in the load path. Such a measurement of the current in the load path requires complicated circuitry.

For example, the document EP 4 054 066 A1 shows a synchronous flyback converter.

Furthermore, the document DE 10 2010 001181 A1 relates to a method for measuring current with a measuring amplifier circuit in a multi-phase power network, in which a desired current is supplied to an electrical load by at least one controllable switching element of a phase, and a control unit generates a control signal having a clock pattern controlling the duty cycle of the respective switching element in order to achieve the desired current supply, wherein clock patterns of the control signals are assigned measuring windows for current measurement, in particular for measuring phase currents, and clock patterns are shifted in time in order to obtain measuring windows of sufficient temporal size. The clock patterns are shifted in ascending order of duty cycle, with the switching element with the shortest duty cycle being switched on first.

Moreover, the document EP 3 926 808 A1 discloses a synchronous flyback converter comprising a first control circuit configured to control a periodic switching of a primary side switch, preferably a MOSFET switch, and a secondary side switch; to measure a level of a drain source voltage Δt discharge of the primary side switch; and to control the primary side switch to be turned on, when said monitored drain source voltage falls below a given voltage level; a second control circuit configured to in case the time duration Δt of the drain source voltage Vds of the first switch dropping below said given voltage value is outside a predetermined range, supply the first control circuit with a modified primary side current value Imax at which the first control circuit switches off the primary side switch.

The document DE 37 05 468 A1 relates to a circuit arrangement for the detection or measurement of the output current of a flyback converter.

The document EP 4 009 506 A1 relates to a synchronous converter for lighting systems.

Measuring the current at different locations than the load path has proven difficult.

Accordingly, the object of the invention is to provide a synchronous flyback converter, which achieves a simple and reliable current measurement.

The object is solved by the features of the independent claims. Additional features of the invention are provided in the dependent claims. In the following, parts of the description and drawings referring to embodiments, which are not covered by the claims are not presented as embodiments of the invention, but as examples useful for understanding the invention.

A synchronous flyback converter with output terminals for supplying a LED load according to a first aspect of the invention comprises a primary side and a secondary side, and a current sensing circuit on the secondary side of the synchronous flyback converter. In this regard, the secondary side comprises a series connection of windings and a secondary side switch, a capacitor circuit comprising a capacitor, preferably an electrolyte capacitor, connected in series to a parallel connection of a first winding of an inductance and a damping resistor. The series connection of windings and the capacitor circuit being connected in parallel to an output capacitor. The secondary side further comprises a current sensing resistor connected in parallel to a second winding of the inductance.

The current sensing circuit is configured to measure the sensing current by measuring a sensing voltage at the current sensing resistor. The current sensing circuit is further configured to sample a sensing current during a current sampling time window, wherein the current sampling time window begins at a current sampling start time. Moreover, the converter further comprises a current sensing timing circuit configured to adjust the current sampling start time.

By adjusting the current sampling start time, and therefore the position of the current sampling time window, it is possible to achieve optimal measuring results in a plateau phase of the current.

Preferably, the current sensing timing circuit is configured to adjust the current sampling start time based on a switching frequency of the converter. This allows for counteracting effects of the switching frequency on the optimum current sampling time.

Advantageously, the sensing timing circuit is moreover configured to adjust the current sampling start time to a first time for a first switching frequency of the converter, and to a second time for a second switching frequency of the converter. The first time therein is later than the second time, and the first switching frequency of the converter is lower than the second switching frequency of the converter. This allows for compensating that the optimum sampling time is sooner for higher switching frequencies and later for lower switching frequencies.

Preferably, the converter comprises a primary side switch configured to repeatedly switch on and off during the operation of the converter. The sensing timing circuit is configured to adjust the current sampling start time to be a correction time interval after a switching on of the primary side switch. This allows for a simple and reliable start of the sampling.

Advantageously, the converter comprises a primary side switch and the secondary side switch. The primary side switch and the secondary side switch are configured to alternatingly switch on and off during operation of the converter. It should be mentioned here that the switches are preferably not switched on simultaneously. It should also be mentioned here that between the switching on and off of the switches, a dead time in which none of the switches is switched on, exists.

The sensing timing circuit is configured to adjust the current sampling start time to be a correction time interval plus a dead time interval after a switching off of the secondary side switch. This allows for a longer time interval from the triggering condition to start the sampling to the actual begin of the sampling. This allows for a simpler circuit construction.

Preferably, the dead time interval is a constant time interval. The sensing timing circuit is moreover configured to adjust the current sampling start time by adjusting a length of the correction time interval. This allows for a highly accurate timing adjustment.

Preferably, the sensing timing circuit is configured to adjust the correction time interval based on the switching frequency of the converter. This allows for a very simple adjustment of the sampling time while achieving high sampling accuracy.

Advantageously, the sensing timing circuit is configured to adjust the correction time interval to a first value for a first switching frequency of the converter, and to a second value for a second switching frequency of the converter. The first value is higher than the second value. The first switching frequency of the converter is lower than the second switching frequency of the converter. This allows for an especially high accuracy of the sampling.

Preferably, the sensing timing circuit is configured to adjust the correction time interval by multiplying a default correction time interval with a correction value, dependent on the switching frequency of the converter.

Alternatively, the sensing timing circuit is configured to adjust the correction time interval by adding a correction value, dependent on the switching frequency of the converter to a default correction time interval. The first option allows for an especially high accuracy of the adjustment, while the second option allows for an especially low computational power to perform the adjustment.

Preferably, the correction value comprises an inverse of the switching frequency. This allows for an especially simple determining of the correction value.

Advantageously, the current sensing timing circuit comprises a correction value determiner, configured to iteratively determine a suitable correction value by increasing the correction value when the current sensing circuit detects a drop off of the sensing current by more than a first threshold during a first part of the current sampling time window, and by decreasing the correction value when the current sensing circuit detects an increase of the sensing current by more than a second threshold during a last part of the current sampling time window. Dynamic factors, such as temperature or humidity can thereby be compensated.

Advantageously, the current sensing circuit is implemented by a first microcontroller. The current sensing timing circuit is implemented by a second microcontroller. The first microcontroller and the second microcontroller are different microcontrollers. Alternatively, the first microcontroller and the second microcontroller are the same microcontroller. These options give great flexibility in circuit construction.

Advantageously, the converter is configured to power at least one LED. This allows for a broad application scope of the converter.

According to a second aspect of the invention, a lighting assembly is provided. The lighting assembly comprises a converter according to the first aspect of the invention, and at least one LED. This allows for an especially efficient operation of the LED, and an especially simple circuit construction.

An exemplary embodiment of the invention is now further explained with regard to the drawings, in which:
- Figure 1: shows a block diagram of a first embodiment of the inventive power converter;
- Figure 2: shows a second more detailed embodiment of the inventive power converter;
- Figure 3: shows a circuit diagram of a third embodiment of the power converter, and
- Figure 4: shows a timing diagram of a fourth embodiment of the inventive power converter.

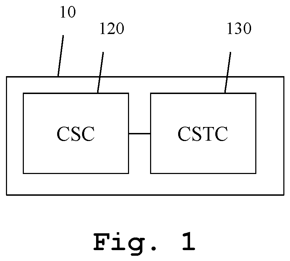

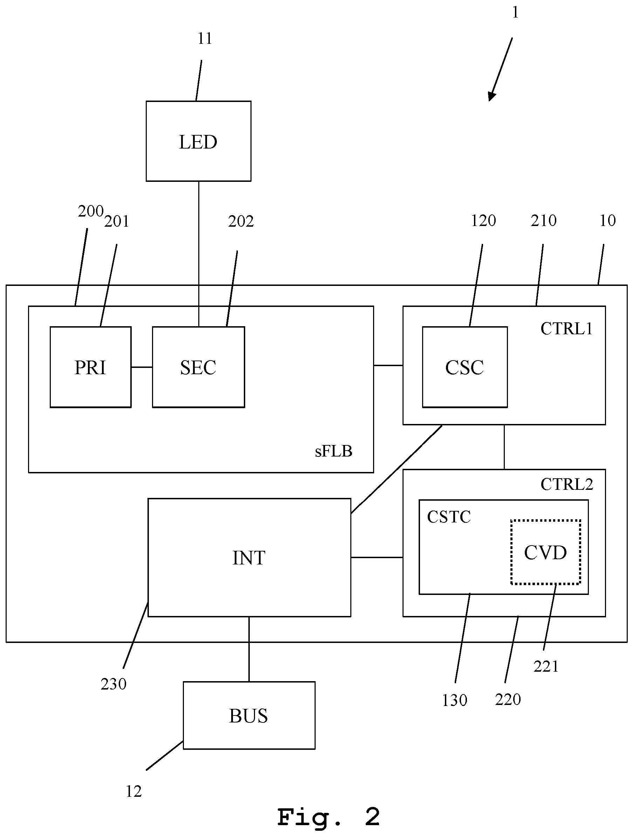

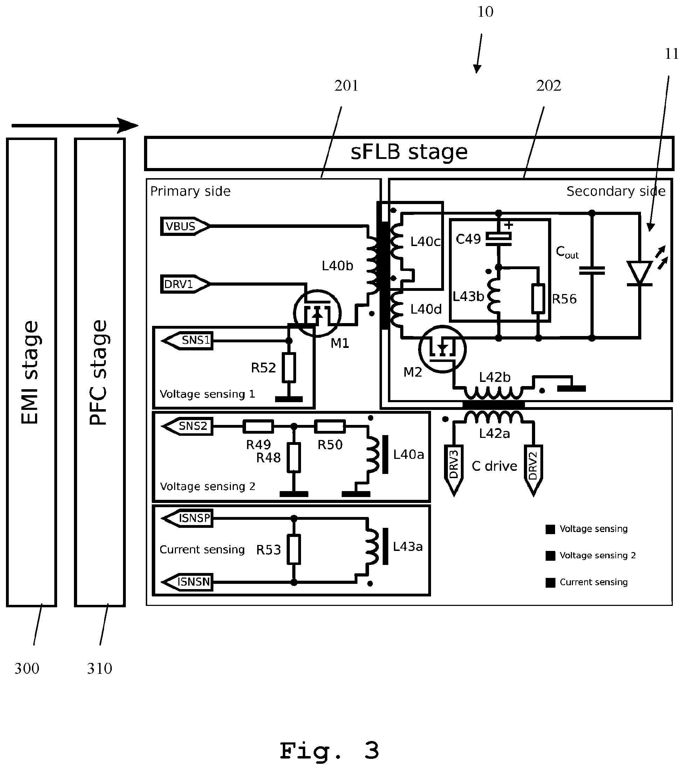

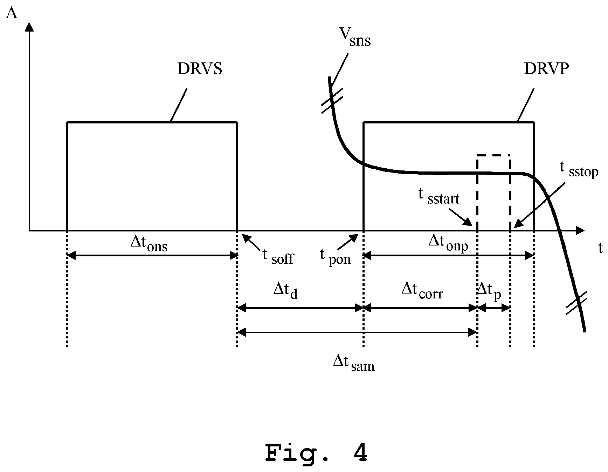

First, the principle function and construction of the power converter will be explained in the basis of Fig. 1. With regard to Fig. 2 and Fig. 3, further construction and function details are shown. Finally, along Fig. 4, the signal timing within the inventive power converter is shown in detail. Similar entities and reference numbers in different Figures have been partially omitted.

In Fig. 1, a first embodiment of the inventive power converter 10 is shown. The power converter 10 comprises a current sensing circuit 120 and a current sensing timing circuit 130. The current sensing circuit is configured to sample a sensing current during a current sampling time window. The current sampling time window begins at a current sampling start time. The current sensing timing circuit 130 is configured to adjust the current sampling start time. Thereby, an optimum current sampling can be achieved, since the current sampling time window can thereby be placed at an optimum position.

In Fig. 2, a more detailed further embodiment of the inventive power converter is shown. Here, additional components of the power converter 10, which are not mandatory elements of the invention are shown. The power converter 10 comprises a synchronized flyback 200, a first controller 210, a second controller 220, and an interface 230. The synchronized flyback 200 is connected to the first controller 210, which in turn is connected to the second controller 220, which again is connected to the interface 230. The synchronized flyback 200 comprises a primary side 201 and a secondary side 202 (defined with reference to the isolation by the flyback transformer). The secondary side 202 may be connected to at least one LED 11, which is not part of the power converter 10.

The first controller 210 comprises the current sensing circuit 120, already described along Fig. 1.

The second controller 220 comprises the current sensing timing circuit 130, already explained along Fig. 1. Optionally, the current sensing timing circuit 130 may further comprise a correction value determiner 221. It is important to note that the first controller 210 and the second controller 220, although depicted as separate controllers here, can be implemented as a single controller. Especially, the controllers can be implemented as ASICs or DSPs.

The interface 230 may moreover be connected with external devices, such as a bus 12, as depicted here. Also, a direct connection to a switch or a different signal source is possible through the interface 230.

The power converter 10 and the at least one LED 11, supplied off output terminals of the power converter 10, form here a lighting assembly 1.

In operation, the first controller 210 controls the operation of the primary side switch on the primary side 201 and the secondary switch of the secondary side 202. When the controller is a synchronized flyback converter, the switches are operated alternatingly with a dead time between the on-times of the switches.

During operation, the current sensing circuit 120 determines the operating current on the secondary side. The operating current is measured during a current sampling time window. The current sampling timing circuit 130 adjusts the start time of the current sampling time window. The correction value determiner 221 may perform a dynamic adjustment of a correction value for correcting the start time of the current sampling time window, if it is present. By use of the interface 230, the operation of the converter, and thereby the operation of the connected at least one LED 11 is controlled.

In Fig. 3, a circuit diagram of the power converter 10 is shown. The power converter 10 here comprises the previously described primary side 201 and secondary side 202. The here-depicted power converter 10 moreover comprises an electromagnetic interference stage 300 and a power factor correction stage 310. These stages, though, are not relevant to the present invention and are only depicted here for reasons of completeness.

The primary side 201 comprises an inductance L40. The winding L40b is part of the primary side, while the inductance L40 constitutes the connection to the secondary side 202. The primary side 201 moreover comprises a primary side switch M1, which is implemented as a transistor.

The control terminal of the primary side switch M1 is connected to a drive signal input DRV1. The winding L40b is connected on its one side to the primary side switch M1, and on its other side to a bus voltage VBUS. The primary side switch M1 is furthermore connected to a resistor R52, which is connected to ground at its other terminal. The connection between the primary side switch M1 and the resistor R52 is used as a first voltage sensing location.

The secondary side 202 is also connected to the inductance L40. The windings L40c and L40d are considered part of the secondary side 202. The windings L40c and L40d are connected in series, electrically. The secondary side 202 comprises a secondary side switch M2, which is connected in series to the winding L40d and the at least one LED 11. In parallel to the series connection of the winding L40c and L40d, is a capacitor circuit, which comprises a capacitor C49, preferably an electrolyte capacitor, which is connected in series to a parallel connection of an inductance L43, especially the winding L43b of the inductance L43 and a damping resistor R56. Moreover, an output capacitor Cₒᵤₜ is connected in parallel to the series connection of the windings L40c and L40d. Also, the at least one LED 11 is connected in parallel here.

The control terminal of the secondary side switch is connected to an inductance L42, especially to a winding L42b of the inductance L42, which is moreover connected to ground.

A winding L40a of the inductance L40 is connected to a resistor R50, which is connected to ground through a shunt resistor R48 for a second voltage sensing. The limiting resistor R49 acts as current limiter.

A winding L42a of the inductance L42 is connected to the driver terminals DRV2 and DRV3, which are connected to the first controller 210, as is the first driver connection DRV1, which operates the primary side switch M1.

A winding L43a of the inductance L43 is connected in parallel to a current sensing resistor R53. The voltage across the current sensing resistor R53 constitutes the sensing voltage, supplied to the current sensing circuit 120, depicted by Fig. 2.

In operation, the first controller 210 alternatingly switches the primary side switch M1 and the secondary side switch M2 so as to achieve synchronized flyback converter operation. The current in the capacitor path is determined by the current sensing circuit 120. Further details of the operation thereof are shown along Fig. 4.

Moreover, the voltage is sensed at the voltage sensing locations SNS1 and SNS2 by the first controller 210. The first controller operates the power converter 10 based upon the first sensed voltage, the second sensed voltage, and the sensed current.

Finally, in Fig. 4, a timing diagram of different signals in an embodiment of the inventive power converter 10 are shown. Here, the activation of the driving signal on the secondary side DRVS and the activation of the driving signal on the primary side DRVP are shown. Moreover, the voltage Vₛₙₛ, which is the current sensing voltage described before, is depicted.

The secondary side switch is on for the duration Δtₒₙₛ. The primary side switch is on during the time interval Δtₒₙₚ. The secondary side switch is deactivated at a time t_{soff}. The primary side switch is activated at a time tₚₒₙ. Between the deactivation of the secondary side switch and the activation of the primary side switch, a dead time Δt_{d} is present. Within the on time of the primary side switch, a current sampling window is located. The current sampling window starts at a time tₛₛₜₐᵣₜ and ends at the time tₛₛₜₒₚ. From the beginning of the primary side switching interval DRVP until the beginning of the sampling window, a time Δt_{corr}, which is referred to as a correction time interval, is present. The sampling window has a length Δtₚ. The sum of the dead time Δt_{d} and the correction time Δt_{corr} is referred to as Δtₛₐₘ.

By adjusting the current sampling start time tₛₛₜₐᵣₜ, it can be assured that the sampling time window is within the plateau phase of the current sensing voltage VSNS.

Due to the frequency-dependent behavior of the capacitor circuit, the current sensing voltage is also frequency-dependent. This means that the plateau phase of the current sensing voltage VSNS is at different positions with regard to the primary side drive pulse. This is accounted for by the current sensing timing circuit changing the correction time Δt_{corr}, accordingly. This can for example be achieved by multiplying a default correction time Δt_{corr,def} by a correction factor x(f). This correction factor can for example comprise an inverse of the present operating frequency, and a constant factor.

Alternatively, the correction can be performed by adding a correction value x(f) to a default correction time Δt_{corr,def}. The correction factor x(f) therein also could for example comprise an inverse of the current operating frequency and a constant term.

Instead of operating with an unchanging correction factor x(f), also a dynamic adjustment can be performed by a correction value determiner 221, which is implemented by the second controller 220. In this case, if a drop-off of the current sensing voltage VSNS towards the beginning of the current sampling window occurs, this indicates that the current sampling window is too early. In this case, the current sensing timing circuit moves the start time to a later time. Furthermore, if a drop-off of the current sensing voltage VSNS towards the end of the current sampling window is detected, this indicates that the current sampling window is placed too late. Then, the current sampling time circuit moves the current sampling window to an earlier time by reducing the time Δt_{corr}.

By this dynamic adjustment, variable factors such as temperature and humidity can be compensated.

## Claims

1. Synchronous flyback converter (10) with output terminals for supplying a LED load, comprising:
- a primary side (201) and a secondary side (202),
- a current sensing circuit (120) on the secondary side of the synchronous flyback converter,
**characterized in that** the secondary side (202) comprises
- a series connection of windings (L40c, L40d) and a secondary side switch (M2),
- a capacitor circuit comprising a capacitor (C49), preferably an electrolyte capacitor, connected in series to a parallel connection of a first winding (L43b) of an inductance (L43) and a damping resistor (R56),
- the series connection of windings (L40c, L40d) and the capacitor circuit (C49, L43b, R56) being connected in parallel to an output capacitor (Cout),
wherein the current sensing circuit (120) comprises a current sensing resistor (R53), connected in parallel to a second winding (L43a) of the inductance (L43),
wherein the current sensing circuit (120) is
- configured to measure the sensing current by measuring a sensing voltage at the current sensing resistor (R53), and is
- configured to sample a sensing current during a current sampling time window, wherein the current sampling time window begins at a current sampling start time (tsstart),
wherein the converter further comprises a current sensing timing circuit configured to adjust the current sampling start time (tsstart).

2. Converter (10) according to claim 1,
wherein the current sensing timing circuit (130) is configured to adjust the current sampling start time (tₛₛₜₐᵣₜ) based on a switching frequency of the converter (10).

3. Converter (10) according to claim 1 or 2,
wherein the sensing timing circuit is configured to adjust the current sampling start time (tₛₛₜₐᵣₜ) to a first time for a first switching frequency of the converter (10), and to a second time for a second switching frequency of the converter (10),
wherein the first time is later than the second time, and wherein the first switching frequency of the converter (10) is lower than the second switching frequency of the converter (10).

4. Converter (10) according to any of claims 1 to 3,
wherein the converter (10) comprises a primary side switch (M1), configured to repeatedly switch on and off during the operation of the converter (10), and
wherein the current sensing timing circuit (130) is configured to adjust the current sampling start time (tₛₛₜₐᵣₜ) to be a correction time interval (Δt_{corr}) after a switching on of the primary side switch (tₚₒₙ).

5. Converter (10) according to any of claims 1 to 4,
wherein the power converter (10) comprises a primary side switch (M1) and the secondary side switch (M2),
wherein the primary side switch (M1) and the secondary side switch (M2) are configured to alternatingly switch on and off during operation of the power converter (10),
wherein the current sensing timing circuit (130) is configured to adjust the current sampling start time (tₛₛₜₐᵣₜ) to be a correction time interval (Δt_{corr}) plus a dead time interval (Δtd) after a switching off of the secondary side switch (t_{soff}).

6. Converter (10) according to claim 5,
wherein the dead time interval (Δt_{d}) is a constant time interval, and
wherein the current sensing timing circuit (130) is configured to adjust the current sampling start time (tₛₛₜₐᵣₜ) by adjusting a length of the correction time interval (Δt_{corr}).

7. Converter (10) according to claim 6,
wherein the current sensing timing circuit (130) is configured to adjust the correction time interval (Δt_{corr}) based on the switching frequency of the converter (10).

8. Converter (10) according to claim 7,
wherein the current sensing timing circuit (130) is configured to adjust the correction time interval (Δt_{corr}) to a first value for a first switching frequency of the converter (10), and to a second value for a second switching frequency of the converter (10),
wherein the first value is higher than the second value, and
wherein the first switching frequency of the converter (10) is lower than the second switching frequency of the converter (10).

9. Converter (10) according to any of claims 5 to 7, wherein the current sensing timing circuit (130) is configured to adjust the correction time interval (Δt_{corr})
- by multiplying a default correction time interval (Δt_{corr,def}) with a correction value x(f), dependent on the switching frequency of the converter (10), or
- by adding a correction value x(f), dependent on the switching frequency of the converter (10) to a default correction time interval (Δt_{corr,def}).

10. Converter (10) according to claim 9,
wherein the correction value x(f) comprises an inverse of the switching frequency.

11. Converter (10) according to claim 9,
wherein the current sensing timing circuit (130) comprises a correction value determiner (221), configured to iteratively determining a suitable correction value, by
- increasing the correction value (Δt_{corr}) when the current sensing circuit (120) detects a drop off of the sensing current by more than a first threshold during a first part of the current sampling time window,
- decreasing the correction value (Δt_{corr}) when the current sensing circuit (120) detects an increase of the sensing current by more than a second threshold during a last part of the current sampling time window.

12. Converter (10) according to any of claims 1 to 11, wherein the converter (10) comprises a first microcontroller (210), configured to control the operation of the converter (10),
wherein the current sampling of the current sensing circuit (120) is implemented by the first microcontroller (210),
wherein the converter (10) comprises a second microcontroller (220),
wherein the current sensing timing circuit (130) is implemented by the second microcontroller (220), and
wherein the first microcontroller (210) is preferably the second microcontroller (220).

13. Converter (10) according to any of claims 1 to 12, wherein the converter (10) is configured to power at least one LED (11).

14. Lighting assembly (1), comprising a converter (10) according to any of the claims 1 to 13, and at least one LED (11) supplied by output terminals of the converter.

## Patentansprüche

1. Synchroner Sperrwandler (10) mit Ausgangsanschlüssen zur Versorgung einer LED-Last, umfassend:
• eine Primärseite (201) und eine Sekundärseite (202),
• eine Stromerfassungsschaltung (120) auf der Sekundärseite des synchronen Sperrwandlers,
**dadurch gekennzeichnet, dass**
die Sekundärseite (202) umfasst
• eine Reihenschaltung von Wicklungen (L40c, L40d) und einem Sekundärseitenschalter (M2),
• eine Kondensatorschaltung, umfassend einen Kondensator (C49), vorzugsweise einen Elektrolytkondensator, der in Reihe mit einer Parallelschaltung einer ersten Wicklung (L43b) einer Induktivität (L43) und eines Dämpfungswiderstands (R56) geschaltet ist,
• wobei die Reihenschaltung der Wicklungen (L40c, L40d) und die Kondensatorschaltung (C49, L43b, R56) parallel zu einem Ausgangskondensator (Cout) geschaltet sind,
wobei die Stromerfassungsschaltung (120)
• einen Stromerfassungswiderstand (R53) umfasst, der parallel zu einer zweiten Wicklung (L43a) der Induktivität (L43) geschaltet ist,
wobei die Stromerfassungsschaltung (120)
• dazu ausgebildet ist, den Erfassungsstrom durch Messen einer Erfassungsspannung am Stromerfassungswiderstand (R53) zu messen, und
• dazu ausgebildet ist, einen Erfassungsstrom während eines Stromabtastzeitfensters abzutasten, wobei das Stromabtastzeitfenster zu einem Stromabtaststartzeitpunkt (tsstart) beginnt,
wobei der Wandler ferner eine Stromerfassungs-Zeitsteuerschaltung aufweist, die dazu ausgebildet ist, den Stromabtaststartzeitpunkt (tsstart) einzustellen.

2. Wandler (10) nach Anspruch 1,
wobei die Stromerfassungs-Zeitsteuerschaltung (130) dazu ausgebildet ist, den Stromabtaststartzeitpunkt (tsstart) in Abhängigkeit von einer Schaltfrequenz des Wandlers (10) einzustellen.

3. Wandler (10) nach Anspruch 1 oder 2,
wobei die Stromerfassungs-Zeitsteuerschaltung dazu ausgebildet ist, den Stromabtaststartzeitpunkt (tsstart) auf einen ersten Zeitpunkt für eine erste Schaltfrequenz des Wandlers (10) und auf einen zweiten Zeitpunkt für eine zweite Schaltfrequenz des Wandlers (10) einzustellen,
wobei der erste Zeitpunkt später als der zweite Zeitpunkt ist, und
wobei die erste Schaltfrequenz des Wandlers (10) niedriger als die zweite Schaltfrequenz des Wandlers (10) ist.

4. Wandler (10) nach einem der Ansprüche 1 bis 3,
wobei der Wandler (10) einen Primärseitenschalter (M1) umfasst, der dazu ausgebildet ist, während des Betriebs des Wandlers (10) wiederholt ein- und auszuschalten, und
wobei die Stromerfassungs-Zeitsteuerschaltung (130) dazu ausgebildet ist, den Stromabtaststartzeitpunkt (tsstart) auf ein Korrekturzeitintervall (Atcorr) nach einem Einschalten des Primärseitenschalters (tpon) einzustellen.

5. Wandler (10) nach einem der Ansprüche 1 bis 4,
wobei der Leistungswandler (10) einen Primärseitenschalter (M1) und den Sekundärseitenschalter (M2) umfasst,
wobei der Primärseitenschalter (M1) und der Sekundärseitenschalter (M2) dazu ausgebildet sind, während des Betriebs des Leistungswandlers (10) abwechselnd ein- und auszuschalten,
wobei die Stromerfassungs-Zeitsteuerschaltung (130) dazu ausgebildet ist, den Stromabtaststartzeitpunkt (tsstart) auf ein Korrekturzeitintervall (Atcorr) zuzüglich eines Totzeitintervalls (Atd) nach einem Ausschalten des Sekundärseitenschalters (tsoff) einzustellen.

6. Wandler (10) nach Anspruch 5,
wobei das Totzeitintervall (Atd) ein konstantes Zeitintervall ist, und
wobei die Stromerfassungs-Zeitsteuerschaltung (130) dazu ausgebildet ist, den Stromabtaststartzeitpunkt (tsstart) durch Einstellen einer Länge des Korrekturzeitintervalls (Atcorr) einzustellen.

7. Wandler (10) nach Anspruch 6,
wobei die Stromerfassungs-Zeitsteuerschaltung (130) dazu ausgebildet ist, das Korrekturzeitintervall (Atcorr) in Abhängigkeit von der Schaltfrequenz des Wandlers (10) einzustellen.

8. Wandler (10) nach Anspruch 7,
wobei die Stromerfassungs-Zeitsteuerschaltung (130) dazu ausgebildet ist, das Korrekturzeitintervall (Atcorr) auf einen ersten Wert für eine erste Schaltfrequenz des Wandlers (10) und auf einen zweiten Wert für eine zweite Schaltfrequenz des Wandlers (10) einzustellen,
wobei der erste Wert größer als der zweite Wert ist, und
wobei die erste Schaltfrequenz des Wandlers (10) niedriger als die zweite Schaltfrequenz des Wandlers (10) ist.

9. Wandler (10) nach einem der Ansprüche 5 bis 7,
wobei die Stromerfassungs-Zeitsteuerschaltung (130) dazu ausgebildet ist, das Korrekturzeitintervall (Atcorr)
• durch Multiplizieren eines Standard-Korrekturzeitintervalls (Atcorr,def) mit einem Korrekturwert x(f), der von der Schaltfrequenz des Wandlers (10) abhängig ist, oder
• durch Addieren eines Korrekturwerts x(f), der von der Schaltfrequenz des Wandlers (10) abhängig ist, zu einem Standard-Korrekturzeitintervall (Atcorr,def)
einzustellen.

10. Wandler (10) nach Anspruch 9,
wobei der Korrekturwert x(f) einen Kehrwert der Schaltfrequenz umfasst.

11. Wandler (10) nach Anspruch 9,
wobei die Stromerfassungs-Zeitsteuerschaltung (130) eine Korrekturwertermittlungseinrichtung (221) umfasst, die dazu ausgebildet ist, iterativ einen geeigneten Korrekturwert zu bestimmen, durch
• Erhöhen des Korrekturwerts (Atcorr), wenn die Stromerfassungsschaltung (120) einen Abfall des Erfassungsstroms um mehr als einen ersten Schwellenwert während eines ersten Teils des Stromabtastzeitfensters erkennt, und
• Verringern des Korrekturwerts (Atcorr), wenn die Stromerfassungsschaltung (120) einen Anstieg des Erfassungsstroms um mehr als einen zweiten Schwellenwert während eines letzten Teils des Stromabtastzeitfensters erkennt.

12. Wandler (10) nach einem der Ansprüche 1 bis 11,
wobei der Wandler (10) einen ersten Mikrocontroller (210) umfasst, der dazu ausgebildet ist, den Betrieb des Wandlers (10) zu steuern,
wobei die Stromabtastung der Stromerfassungsschaltung (120) durch den ersten Mikrocontroller (210) implementiert ist,
wobei der Wandler (10) einen zweiten Mikrocontroller (220) umfasst,
wobei die Stromerfassungs-Zeitsteuerschaltung (130) durch den zweiten Mikrocontroller (220) implementiert ist, und
wobei der erste Mikrocontroller (210) vorzugsweise derselbe Mikrocontroller wie der zweite Mikrocontroller (220) ist.

13. Wandler (10) nach einem der Ansprüche 1 bis 12,
wobei der Wandler (10) dazu ausgebildet ist, mindestens eine LED (11) mit Leistung zu versorgen.

14. Beleuchtungsanordnung (1),
umfassend einen Wandler (10) nach einem der Ansprüche 1 bis 13 und mindestens eine LED (11), die durch Ausgangsanschlüsse des Wandlers versorgt wird.

## Revendications

1. Convertisseur flyback synchrone (10) comportant des bornes de sortie destinées à alimenter une charge à DEL, comprenant :
• un côté primaire (201) et un côté secondaire (202),
• un circuit de détection de courant (120) sur le côté secondaire du convertisseur flyback synchrone,
**caractérisé en ce que**
le côté secondaire (202) comprend
• une connexion en série d'enroulements (L40c, L40d) et d'un interrupteur côté secondaire (M2),
• un circuit capacitif comprenant un condensateur (C49), de préférence un condensateur électrolytique, connecté en série à une connexion en parallèle d'un premier enroulement (L43b) d'une inductance (L43) et d'une résistance d'amortissement (R56),
• la connexion en série des enroulements (L40c, L40d) et le circuit capacitif (C49, L43b, R56) étant connectés en parallèle à un condensateur de sortie (Cout),
dans lequel le circuit de détection de courant (120) comprend
• une résistance de détection de courant (R53), connectée en parallèle à un second enroulement (L43a) de l'inductance (L43),
dans lequel le circuit de détection de courant (120)
• est configuré pour mesurer le courant de détection en mesurant une tension de détection au niveau de la résistance de détection de courant (R53), et
• est configuré pour échantillonner un courant de détection pendant une fenêtre temporelle d'échantillonnage du courant, la fenêtre temporelle d'échantillonnage du courant commençant à un instant de début d'échantillonnage du courant (tsstart),
le convertisseur comprenant en outre un circuit de temporisation de détection de courant configuré pour ajuster l'instant de début d'échantillonnage du courant (tsstart).

2. Convertisseur (10) selon la revendication 1,
dans lequel le circuit de temporisation de détection de courant (130) est configuré pour ajuster l'instant de début d'échantillonnage du courant (tsstart) en fonction d'une fréquence de commutation du convertisseur (10).

3. Convertisseur (10) selon la revendication 1 ou 2,
dans lequel le circuit de temporisation de détection de courant est configuré pour ajuster l'instant de début d'échantillonnage du courant (tsstart) à un premier instant pour une première fréquence de commutation du convertisseur (10), et à un second instant pour une seconde fréquence de commutation du convertisseur (10),
dans lequel le premier instant est postérieur au second instant, et
dans lequel la première fréquence de commutation du convertisseur (10) est inférieure à la seconde fréquence de commutation du convertisseur (10).

4. Convertisseur (10) selon l'une quelconque des revendications 1 à 3,
dans lequel le convertisseur (10) comprend un interrupteur côté primaire (M1), configuré pour être mis en conduction et hors conduction de manière répétée pendant le fonctionnement du convertisseur (10), et
dans lequel le circuit de temporisation de détection de courant (130) est configuré pour ajuster l'instant de début d'échantillonnage du courant (tsstart) de sorte qu'il corresponde à un intervalle de temps de correction (Atcorr) après une mise en conduction de l'interrupteur côté primaire (tpon).

5. Convertisseur (10) selon l'une quelconque des revendications 1 à 4,
dans lequel le convertisseur de puissance (10) comprend un interrupteur côté primaire (M1) et l'interrupteur côté secondaire (M2),
dans lequel l'interrupteur côté primaire (M1) et l'interrupteur côté secondaire (M2) sont configurés pour être mis alternativement en conduction et hors conduction pendant le fonctionnement du convertisseur de puissance (10),
dans lequel le circuit de temporisation de détection de courant (130) est configuré pour ajuster l'instant de début d'échantillonnage du courant (tsstart) de sorte qu'il corresponde à un intervalle de temps de correction (Atcorr) augmenté d'un intervalle de temps mort (Atd) après une mise hors conduction de l'interrupteur côté secondaire (tsoff).

6. Convertisseur (10) selon la revendication 5,
dans lequel l'intervalle de temps mort (Atd) est un intervalle de temps constant, et
dans lequel le circuit de temporisation de détection de courant (130) est configuré pour ajuster l'instant de début d'échantillonnage du courant (tsstart) en ajustant une durée de l'intervalle de temps de correction (Atcorr).

7. Convertisseur (10) selon la revendication 6,
dans lequel le circuit de temporisation de détection de courant (130) est configuré pour ajuster l'intervalle de temps de correction (Atcorr) en fonction de la fréquence de commutation du convertisseur (10).

8. Convertisseur (10) selon la revendication 7,
dans lequel le circuit de temporisation de détection de courant (130) est configuré pour ajuster l'intervalle de temps de correction (Atcorr) à une première valeur pour une première fréquence de commutation du convertisseur (10), et à une seconde valeur pour une seconde fréquence de commutation du convertisseur (10),
dans lequel la première valeur est supérieure à la seconde valeur, et
dans lequel la première fréquence de commutation du convertisseur (10) est inférieure à la seconde fréquence de commutation du convertisseur (10).

9. Convertisseur (10) selon l'une quelconque des revendications 5 à 7,
dans lequel le circuit de temporisation de détection de courant (130) est configuré pour ajuster l'intervalle de temps de correction (Atcorr)
• en multipliant un intervalle de temps de correction par défaut (Atcorr,def) par une valeur de correction x(f), dépendant de la fréquence de commutation du convertisseur (10), ou
• en ajoutant une valeur de correction x(f), dépendant de la fréquence de commutation du convertisseur (10), à un intervalle de temps de correction par défaut (Atcorr,def).

10. Convertisseur (10) selon la revendication 9,
dans lequel la valeur de correction x(f) comprend l'inverse de la fréquence de commutation.

11. Convertisseur (10) selon la revendication 9,
dans lequel le circuit de temporisation de détection de courant (130) comprend un dispositif de détermination de valeur de correction (221), configuré pour déterminer itérativement une valeur de correction appropriée, en
• augmentant la valeur de correction (Atcorr) lorsque le circuit de détection de courant (120) détecte une diminution du courant de détection supérieure à un premier seuil pendant une première partie de la fenêtre temporelle d'échantillonnage du courant, et
• diminuant la valeur de correction (Atcorr) lorsque le circuit de détection de courant (120) détecte une augmentation du courant de détection supérieure à un second seuil pendant une dernière partie de la fenêtre temporelle d'échantillonnage du courant.

12. Convertisseur (10) selon l'une quelconque des revendications 1 à 11,
dans lequel le convertisseur (10) comprend un premier microcontrôleur (210), configuré pour commander le fonctionnement du convertisseur (10),
dans lequel l'échantillonnage du courant du circuit de détection de courant (120) est mis en œuvre par le premier microcontrôleur (210),
dans lequel le convertisseur (10) comprend un second microcontrôleur (220),
dans lequel le circuit de temporisation de détection de courant (130) est mis en œuvre par le second microcontrôleur (220), et
dans lequel le premier microcontrôleur (210) est de préférence identique au second microcontrôleur (220).

13. Convertisseur (10) selon l'une quelconque des revendications 1 à 12,
dans lequel le convertisseur (10) est configuré pour alimenter au moins une DEL (11).

14. Ensemble d'éclairage (1),
comprenant un convertisseur (10) selon l'une quelconque des revendications 1 à 13 et au moins une DEL (11) alimentée par les bornes de sortie du convertisseur.
